# EUROPEAN PATENT APPLICATION

(11) **EP 4 440 270 A1**
(43) Date of publication of application: **02.10.2024**
(21) Application number: 23166022.6
(22) Date of filing: 31.03.2023
(51) Int. Cl.: H05K 7/20

(54) **A REMOVABLE ADAPTER FOR AN UPGRADABLE ELECTRONIC CONTROL UNIT**

(71) Applicant: Aptiv Technologies AG, 8200 Schaffhausen (CH)
(72) Inventor: BARUS, Lukasz, Dublin, 2 (IE); PRZYJEMSKI, Michal, Dublin, 2 (IE); TYNIEC, Maciej, Dublin, 2 (IE)
(74) Representative: Lewis Silkin LLP

(57) **Abstract**

A removable adapter (10) for a housing (30) of an upgradable electronic control unit. The removable adapter (10) comprising a body (11) having a top surface (12) and a base surface (13). The base surface (13) configured to contact the housing (30). The top surface (12) comprising one or more pedestals (14) configured for contacting one or more electronic components of a PCB.

## Description

### Introduction

The present disclosure relates to an adapter for an upgradable electronic control unit, in particular an adapter providing a thermal and mechanical contact between a printed circuit board and a housing of an upgradable unit. The present disclosure is particularly relevant to adapters for units in a vehicle that have upgradable electronic components.

### Background

Electronic control units (ECUs) are provided to house electrical components and to provide electric connections between said components and/or wires in many fields. ECUs may be used in a variety of devices, machines, and vehicles (e.g. automobiles, ships, and aircraft).

ECUs typically comprise a printed circuit board (PCB) supporting one or more integrated circuit (IC) chips with a particular layout. However, over the lifetime of the unit, the IC chip on the PCB may need to be exchanged to provide upgrades to the electronics unit, or to change components on the PCB. A new layout of IC chips on a PCB may require a replacement of the whole electronics unit which leads to additional costs and increased material usage. It is also well known that electronic components on the PCB may generate heat in use and so any heat sink structures need to be maintained after the upgrade is performed.

Accordingly, there is a need to provide an upgradable unit by which the aforementioned problems are overcome. In particular, an upgradable unit that does not require complete replacement when components within the unit are changed and/or upgraded.

### Summary

In light of the above, the present invention seeks to propose an improvement, particularly a replaceable heat transfer device that enables the substitution and/or upgrade of electronic components within the housing of an electronic control unit, thereby minimising material usage and reducing costs associated with manufacturing complete units. The heat transfer device is referred to herein as a "removable adapter" and is understood to function as any suitably formed block or plate of heat conductive material which can contact and provide a bridge for heat transfer between an electronic component on a PCB and the internal wall of a housing, which further functions to dissipate heat from the electronic components which generate heat in use.

A first aspect of the invention is outlined according to claim 1 of the appended claims. Broadly, a removable adapter for a housing of an upgradable electronic control unit, comprising a body forming a top surface and a base surface. The base surface of the body configured to contact the housing, and the top surface of the body comprising one or more pedestals configured for contacting one or more electronic components of a PCB.

In this way, the adapter is configured to be removable from an ECU, along with a corresponding PCB, so that the ECU can be upgraded, or at least replaced (e.g. for repair), with a new PCB and its electronic functions. The adapter provides an interface between the PCB and a wall of the ECU housing that functions as a bridge for heat transfer, so that the heat dissipating function of the housing or an associated heat sink can be maintained.

The term "pedestal" used herein refers to a part of the removable adapter that protrudes out from the top surface. For example, the term "pedestal" can be used interchangeably with terms column, plinth, platform, or support.

In one form, each of the one or more pedestals comprise a contact surface. The contact surface being defined by an area and located at a height above the top surface (i.e., the height of the pedestal from the top surface of the body). In this way, the contact surface can be configured to contact a surface of an electronic component that, in use, will generate heat.

In one form, at least two of the contact surfaces of the one or more pedestals have an area and/or height that is different. In an alternate form, at least two of the contact surfaces of the one or more pedestals have an area and/or height that is the same. A contact surface may, in practice, span more than one PCB components if they are of the same height from the board.

In one form, the body further comprises a securing means for coupling the body to the housing. The securing means can be a hole configured to receive a fastener. In this way, the adapter is securable to the housing and/or PCB so that a heat bridge is maintained.

In one form, the base surface comprises one or more locating pins. A pin is able to simplify locating the adapter upon a surface of the housing, i.e. an interface surface.

In a further aspect, the body housing is formed of a heat conductive material, such as a metallic alloy. The body can be manufactured from an aluminium alloy and can be die-cast. In this way, the adapter is heat conducting and may be formed by an efficient process. In practice, a large number of adapters may be produced to correspond with a PCB upgrade program for an ECU.

A second aspect of the invention is outlined according to claim 11 of the appended claims. Broadly, an upgradable electronic control unit comprising a removable adapter, being of any configuration as described herein. The upgradable electronic control unit further comprising a housing. The housing comprising an interface configured to receive the removable adapter. The upgradable electronic control unit further comprising a printed circuit board supporting one or more integrated circuit chips, wherein the one or more pedestals of the removable adapter contact the one or more integrated circuit chips.

In one form, the unit comprises a first layer of thermal interface material between the removable adapter and the housing. In this way, heat transfer is facilitated so that the adapter can function as a bridge between PCB components and the housing and/or associated heat sink. At the same time, the one or more pedestals of the removable adapter are in thermal contact with the one or more integrated circuit chips via standard thermal interface material, so the combined assembly executes the role of thermal bridge with low thermal resistance assured.

In a further form, the housing is a die-cast aluminium alloy. However, any suitable material can be used that can act as a heat transfer device.

A third aspect of the invention is outlined according to claim 15 of the appended claims, namely a method of upgrading an ECU by substituting both a printed circuit board and corresponding adapter, where the PCB will provide updated functionality. In the case of mere repair, a PCB may be replaced without changing the adapter.

The invention is applicable not only to automotive applications, but to any field where electrical components are changed and/or upgraded within a housing of an upgradable unit.

The same approach in design may be executed in applications with at least two different circuit boards with separate layouts of ICs, but same housing. By applying an adapter specified for a particular circuit board, one housing may be maintained.

### Brief Description of Drawings

Illustrative embodiments will now be described with reference to the accompanying drawings in which:
Figure 1 illustrates a perspective overview of a removable adapter according to one aspect of the present disclosure;
Figure 2 illustrates a perspective underview of a removable adapter according to one aspect of the present disclosure;
Figure 3 illustrates a top view of a removable adapter according to one aspect of the present disclosure;
Figure 4 illustrates a bottom view of a removable adapter according to one aspect of the present disclosure;
Figure 5 illustrates a side view of a removable adapter according to one aspect of the present disclosure;
Figure 6 illustrates a perspective overview of one half of a housing for an upgradable unit according to one aspect of the present disclosure;
Figure 7 illustrates a top view of the upgradable unit from Figure 6; and
Figure 8 illustrates a sectional view of an upgradable unit along the line A-A of Figure 7.

### Detailed Description

The following description presents exemplary embodiments and, together with the drawings, serves to explain principles of the invention. However, the scope of the invention is not intended to be limited to the precise details of the embodiments or exact adherence with all features and/or method steps of implementation, since variations will be apparent to a skilled person and are deemed also to be covered by the description. Terms for components used herein should be given a broad interpretation that also encompasses equivalent functions and features. In some cases, several alternative terms (synonyms) for structural features have been provided but such terms are not intended to be exhaustive. Descriptive terms should also be given the broadest possible interpretation; e.g. the term "comprising" as used in this specification means "consisting at least in part of" such that interpreting each statement in this specification that includes the term "comprising", features other than that, in addition to, or those prefaced by the term may also be present. Related terms such as "comprise" and "comprises" are to be interpreted in the same manner. Directional terms such as "vertical", "horizontal", "up", "down", "sideways", "upper" and "lower" are used for convenience of explanation usually with reference to the orientation shown in illustrations and are not intended to be ultimately limiting if an equivalent function can be achieved with an alternative dimension and/or direction. Therefore, all directional terms are merely relative to each other.

The description herein refers to embodiments with particular combinations of steps or features, however, it is envisaged that further combinations and crosscombinations of compatible steps or features between embodiments will be possible. Indeed, isolated features may function independently as an invention from other features and not necessarily require implementation as a complete combination.

It will be understood that the illustrated embodiments show applications only for the purposes of explanation. In practice, the invention may be applied to many different configurations, where the embodiment is straightforward for those skilled in the art to implement.

Automotive vehicles consist of numerous upgradable electrical units such as, but not limited to, the electronic control unit (ECU) and infotainment unit. These units include electronic components, which may be upgraded and/or changed during the lifespan of the automotive vehicle. For example, the infotainment unit may be upgraded to support extra functions and/or to replace existing electronic components for newer versions. However, there are multiple disadvantages associated with conventional units that will be addressed in the present disclosure.

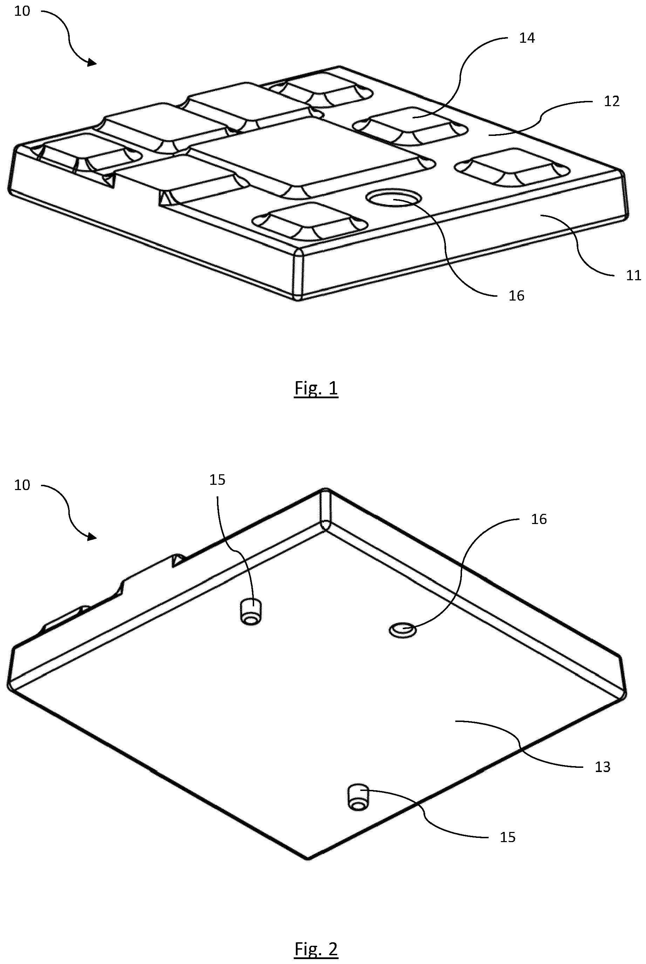

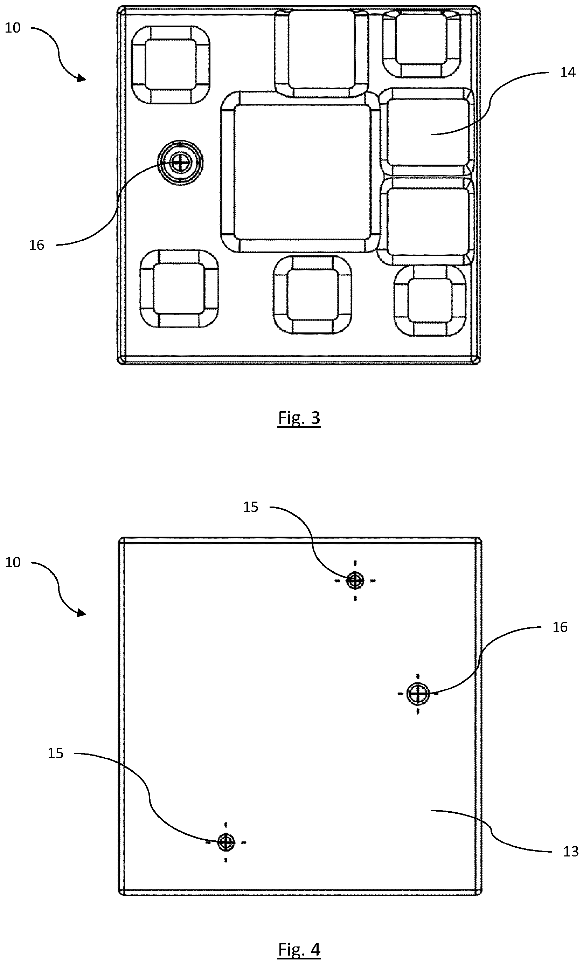

Figs. 1-5 show a removable adapter 10 according to one arrangement of this disclosure. The removable adapter 10 comprises a body 11 having a top surface 12 and a base surface 13. The base surface 13 is configured to contact the housing to secure the removable adapter 10 to the housing of the unit. The top surface 12 comprises one or more pedestals 14 configured to contact electrical components. The height of pedestals 14 and/or the thickness of body 11 of the adapter 10 is at least 2.0 mm.

The body 11 of the removable adapter 10 can be made of any suitable material, such as plastic, metal, or a combination thereof. Preferably, the body 11 of the removable adapter 10 is made from a heat conductor such as aluminium, or an aluminium alloy. In some arrangements, the body 11 of the removable adapter 10 may be moulded or machined to form the desired shape and size for the removable adapter 10. For example, the removable adapter 10 can be made by die casting a metal, such as an aluminium alloy. The base surface 13 of the removable adapter 10 may comprise one or more locating pins 15 to correctly position the removable adapter 10 in the housing. Two or more locating pins 15 ensure that the adapter cannot rotate relative to the housing.

The one or more pedestals 14 protruding from the top surface 12 (i.e. embossed, die cast) of the removable adapter 10 are configured to correspond with a layout of IC chips on a PCB of the electrical component. The one or more pedestals 14 can be arranged in any suitable configuration (e.g. area and height) to match the layout of the IC chips on the PCB. For example, the one or more pedestals 14 may be arranged in a linear or grid pattern, or any combination thereof.

The one or more pedestals 14 of the removable adapter 10 are, in use, in thermal contact with the one or more IC chips on the PCB. In some arrangements, the housing of the control unit functions as a heatsink, or heat spreader. As such, the removable adapter 10 acts to provide a thermal interface or bridge between the housing and the IC chips on the PCB. Therefore, heat can be dissipated from the IC chips on the PCB and transferred to the housing to reduce the temperature of the IC chips.

In one arrangement, the removable adapter 10 comprises a securing means for coupling the body 11 of the removable adapter 10 to the housing. In the illustrated form, the securing mechanism includes a hole 16 into which a fastener is inserted to couple the removable adapter 10 to the housing. However, other suitable arrangements or surface features to couple the removable adapter 10 to the housing can be used. For example, clips, sliding guides/rails provided on the housing may be used to couple the removable adapter 10 to the housing.

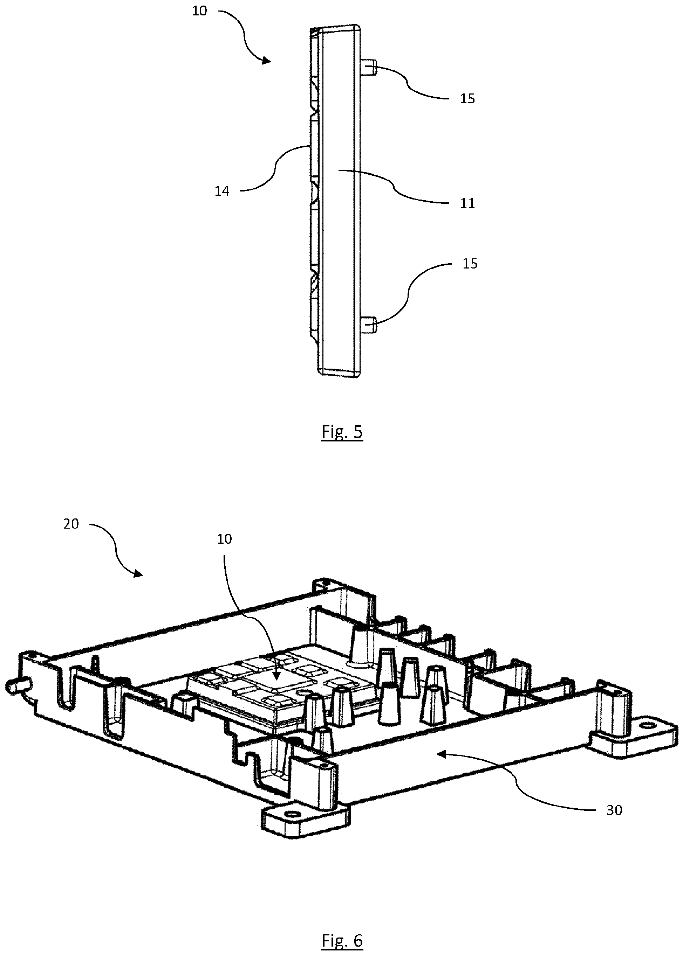

Figs. 6-8 show an ECU 20 that is configured to be upgradable according to one arrangement of this disclosure. The upgradable unit comprises the removable adapter 10, a housing 30 (one half of which is shown) and a PCB supporting one or more IC chips (not shown, since it is not yet in place). The removable adapter 10 can be positioned in any location within the housing according to corresponding PCB location. The housing 30 comprises an interface 31 into which the removable adapter is positioned once assembled. The interface 31 can be raised from the surface of the housing or can be level with the surface of the housing. The removable adapter 10 is coupled within the housing 30 but can be of any dimension to fit within the housing 30. For example, the removable adapter 10 can be substantially the same size as the housing 30 if required.

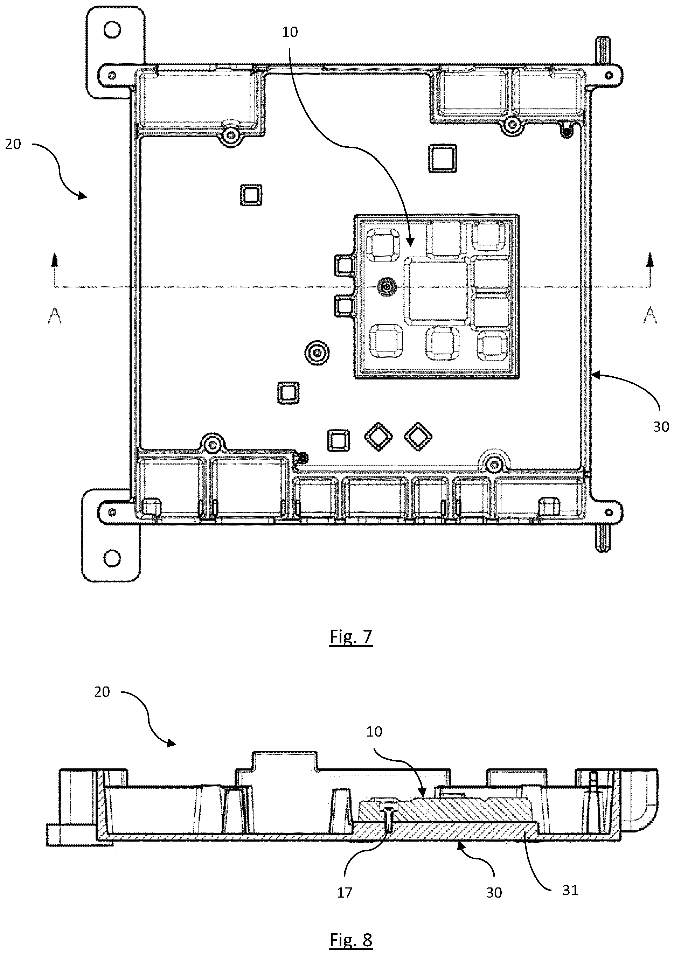

As shown in Fig. 8, the removable adapter 10 may be coupled to the housing 30 of the unit 20 by a fastener 17 in one example of this disclosure. For example, the fastener 17 can be a screw, bolt, or pin for securing the removable adapter 10 to the housing 30. The fastener 17 ensures that the removable adapter 10 is located in the correct position within the housing 30 and that the removable adapter 10 remains in a fixed position relative to the housing 30 and the PCB with which it is in contact. Thermal contact between the adapter 10 and the interfacing surface [give number] of housing 30 can be facilitated by use of a thermal interface material (TIM), greases, etc. Likewise, the contact surfaces between components of the PCB and the pedestals 14 can include a TIM.

The removable adapter described herein provides a convenient and versatile solution for upgrading or replacing electrical components in an upgradable unit. Specifically, when the layout of IC chips on a PCB are altered to include upgrades and/or other modifications. The adapter is easy to install and remove and can be used when new features are added and/or replaced on a PCB without the need to replace the whole housing. Therefore, the removable adapter 10 improves sustainability and reduces aluminium reusage for upgradable units. Using the removable adapter 10 reduces new aluminium usage when upgrading units. For example, conventionally the whole housing would be replaced when electronic components are upgraded or changed on the PCB, which requires approximately 500g of aluminium to produce. The removable adapter 10 of the present disclosure reduces the new aluminium required to around 50-100g.

Although an overview of the inventive subject matter has been described with reference to specific example embodiments, various modifications and changes may be made to these embodiments without departing from the broader scope defined by the appended claims.

## Claims

1. A removable adapter for a housing of an upgradable electronic control unit, the adapter comprising:
a body comprising a top surface and a base surface, the base surface configured to contact the housing, and the top surface comprising one or more pedestals configured for contacting one or more electronic components of a PCB.

2. The removable adapter according to claim 1, wherein each of the one or more pedestals comprise a contact surface, the contact surface forming an area and located at a height, and wherein at least two of the contact surfaces of the one or more pedestals have an area and/or height that is different.

3. The removable adapter according to claim 2, wherein at least two of the contact surfaces of the one or more pedestals have an area and/or height that is the same.

4. The removable adapter according to any preceding claim, the body further comprising a securing feature for coupling the body to the housing.

5. The removable adapter according to claim 4, wherein the securing feature is selected from one or more of a hole configured for receiving a fastener, a clip, guide rail.

6. The removable adapter according to any preceding claim, wherein the base surface comprises one or more locating pins.

7. The removable adapter according to any preceding claims, wherein the body housing is formed of a heat conductive material.

8. The removable adapter according to claim 7, wherein the body is an aluminium alloy.

9. An electronic control unit comprising:
a removable adapter according to any preceding claim;
a housing, the housing comprising an interface portion configured to receive the removable adapter; and
a printed circuit board supporting one or more electronic components, wherein the one or more pedestals of the removable adapter contact the one or more electronic components.

10. The unit according to claim 9, wherein the unit comprises a first layer of thermal interface material between the removable adapter and the interface portion of the housing.

11. The unit according to any one of claims 9-10, comprising a second layer of thermal interface material between the one or more pedestals of the removable adapter and the one or more electronic components.

12. The unit according to any one of claims 9-11, wherein the housing is a die-cast aluminium alloy or stamped sheet metal.

13. A method of upgrading an electronic control unit, comprising:
opening the housing of an electronic control unit according to any of claims 9 to 12;
removing the printed circuit board;
substituting the removable adapter with a second removable adapter configured for interfacing with a second printed circuit board;
securing the removable adapter to the interface portion;
securing the second printed circuit board over the second removable adapter such that the one or more electronic components are in thermal contact with corresponding one or more pedestals of the removable adapter.
